# EUROPEAN PATENT APPLICATION

(11) **EP 2 793 252 A1**
(43) Date of publication of application: **22.10.2014**
(21) Application number: 12857979.4
(22) Date of filing: 01.11.2012
(51) Int. Cl.: H01L 21/28, H01L 21/20, H01L 21/265, H01L 21/3205, H01L 21/336, H01L 21/768, H01L 23/532, H01L 29/12, H01L 29/78

(54) **METHOD FOR MANUFACTURING SEMICONDUCTOR DEVICE**

(30) Priority: 12.12.2011 JP 2011270857
(71) Applicant: Sumitomo Electric Industries, Ltd., Osaka-shi, Osaka 541-0041 (JP)
(72) Inventor: HORII, Taku, Osaka-shi, Osaka 554-0024 (JP)
(74) Representative: Grünecker, Kinkeldey, Stockmair & Schwanhäusser
(86) International application number: PCT/JP2012/078300
(87) International publication number: WO 2013/088855

(57) **Abstract**

A method for manufacturing a semiconductor device includes the steps of: preparing a substrate (10); forming a gate insulating film (20); forming a gate electrode (30); forming an interlayer insulating film (40) to surround the gate electrode (30); forming a contact hole extending through the interlayer insulating film (40) to expose a main surface (10A) of the substrate (10); and forming a first metal film (51) on and in contact with a side wall surface of the contact hole, the first metal film (51) containing at least one of Ti and Si and containing no Al; forming a second metal film (52) containing Ti, Al, and Si on and in contact with the first metal film (51); and forming a source electrode containing Ti, Al, and Si by heating the first and second metal films (51,52).

## Description

### TECHNICAL FIELD

The present invention relates to a method for manufacturing a semiconductor device, more particularly, a method for manufacturing a semiconductor device, by which a semiconductor device having a stable characteristic can be manufactured by improving adhesion between an electrode containing aluminum and an interlayer insulating film.

### BACKGROUND ART

An electrode containing aluminum (A1) may be employed for a source electrode of a MOSFET (Metal Oxide Semiconductor Field Effect Transistor) or an emitter electrode of an IGBT (Insulated Gate Bipolar Transistor). For example, in the MOSFET, a positional relation or the like between such a source electrode containing Al and each of a gate electrode, a gate insulating film, and an interlayer insulating film has been considered (for example, see United States Patent No. 6,833,562 (Patent Literature 1) and Japanese Patent Laying-Open No. 2000-012846 (Patent Literature 2)).

### CITATION LIST

### PATENT LITERATURE

PTL 1: United States Patent No. 6,833,562
PTL 2: Japanese Patent Laying-Open No. 2000-012846

### SUMMARY OF INVENTION

### TECHNICAL PROBLEM

In the MOSFET, the source electrode may be formed on and in contact with a surface of a substrate having an active region formed therein, and in contact with a side wall surface of an interlayer insulating film formed to surround the gate electrode on the surface. Here, if adhesion between the source electrode and the interlayer insulating film is insufficient, the source electrode comes off, thus affecting a device characteristic of the MOSFET.

The present invention has been made in view of the foregoing problem, and has its object to provide a method for manufacturing a semiconductor device, by which a semiconductor device having a stable characteristic can be manufactured by improving adhesion between an electrode containing aluminum and an interlayer insulating film.

### SOLUTION TO PROBLEM

A method for manufacturing a semiconductor device in the present invention includes the steps of: preparing a substrate made of silicon carbide; forming a gate insulating film on a surface of the substrate; forming a gate electrode on the gate insulating film; forming an interlayer insulating film on the gate insulating film so as to surround the gate electrode; forming a contact hole extending through the interlayer insulating film to expose the surface of the substrate and separated from the gate electrode; forming a first metal film on and in contact with a side wall surface of the contact hole, the first metal film containing at least one of Ti and Si and containing no Al; forming a second metal film containing Ti, Al, and Si on and in contact with the first metal film; and forming a source electrode containing Ti, Al, and Si by heating the first and second metal films.

Here, the expression "first metal film containing no Al" is intended to indicate a first metal film containing substantially no Al. Specifically, the first metal film is intended to indicate a metal film in which Al is not added intentionally, and include a first metal film in which Al is contained as an impurity, for example.

In the method for manufacturing the semiconductor device in the present invention, the source electrode containing Al is formed in the following manner. First, the contact hole is formed to extend through the interlayer insulating film surrounding the gate electrode, and the first metal film containing at least one of Ti and Si is formed on and in contact with the side wall surface of the contact hole. Next, the second metal film containing Ti, Al, and Si is formed on and in contact with the first metal film. Then, by heating the first and second metal films, the source electrode containing Ti, Al, and Si is formed. Thus, in the method for manufacturing the semiconductor device in the present invention, adhesion between the source electrode and the interlayer insulating film can be improved by forming the first metal film, which contains at least one of Ti and Si, in advance on and in contact with the side wall surface of the contact hole. Hence, according to the method for manufacturing the semiconductor device in the present invention, there can be provided a method for manufacturing a semiconductor device, by which a semiconductor device having a stable characteristic can be manufactured by improving adhesion between the source electrode, which is an electrode containing aluminum, and the interlayer insulating film.

In the method for manufacturing the semiconductor device, in the step of forming the second metal film, the second metal film may be formed in contact with the surface of the substrate exposed by forming the contact hole.

By thus forming the second metal film securely in contact with the surface of the substrate exposed by forming the contact hole, a semiconductor device having a stable characteristic can be manufactured more readily.

In the method for manufacturing the semiconductor device, in the step of forming the second metal film, the second metal film may be formed to have a first metal layer, a second metal layer, and a third metal layer stacked on one another, the first metal layer containing Ti, the second metal layer being on and in contact with the first metal layer and containing Al, the third metal layer being on and in contact with the second metal layer and containing Si. Alternatively, in the method for manufacturing the semiconductor device, in the step of forming the second metal film, the second metal film may be formed to contain Ti, Al, and Si mixed with one another. In this way, the second metal film can be formed readily.

In the method for manufacturing the semiconductor device, in the step of forming the first metal film, the first metal film may be formed to have a thickness of not less than 0.1 µm and not more than 1 µm. Thus, the thickness of the first metal film can be set in a range necessary to improve adhesion between the source electrode and the interlayer insulating film.

In the method for manufacturing the semiconductor device, in the step of forming the first metal film, the first metal film may be formed to contain Ti and contain no Al. In this way, the adhesion between the source electrode and the interlayer insulating film can be further improved.

### ADVANTAGEOUS EFFECTS OF INVENTION

As apparent from the description above, according to the method for manufacturing the semiconductor device in the present invention, there can be provided a method for manufacturing a semiconductor device, by which a semiconductor device having a stable characteristic can be manufactured by improving adhesion between an electrode containing aluminum and an interlayer insulating film.

### BRIEF DESCRIPTION OF DRAWINGS

Fig. 1 is a schematic cross sectional view showing a structure of a MOSFET.
Fig. 2 is a flowchart schematically showing a method for manufacturing the MOSFET.
Fig. 3 is a schematic cross sectional view for illustrating the method for manufacturing the MOSFET.
Fig. 4 is a schematic cross sectional view for illustrating the method for manufacturing the MOSFET.
Fig. 5 is a schematic cross sectional view for illustrating the method for manufacturing the MOSFET.
Fig. 6 is a schematic cross sectional view for illustrating the method for manufacturing the MOSFET.
Fig. 7 is a schematic cross sectional view for illustrating the method for manufacturing the MOSFET.
Fig. 8 is a schematic cross sectional view for illustrating the method for manufacturing the MOSFET.
Fig. 9 is a schematic cross sectional view for illustrating the method for manufacturing the MOSFET.
Fig. 10 is a schematic cross sectional view for illustrating the method for manufacturing the MOSFET.
Fig. 11 is a schematic cross sectional view for illustrating the method for manufacturing the MOSFET.
Fig. 12 is an enlarged view schematically showing a structure of a second metal film in Fig. 11.
Fig. 13 is a schematic cross sectional view for illustrating the method for manufacturing the MOSFET.

### DESCRIPTION OF EMBODIMENTS

The following describes an embodiment of the present invention with reference to figures. It should be noted that in the below-mentioned figures, the same or corresponding portions are given the same reference characters and are not described repeatedly.

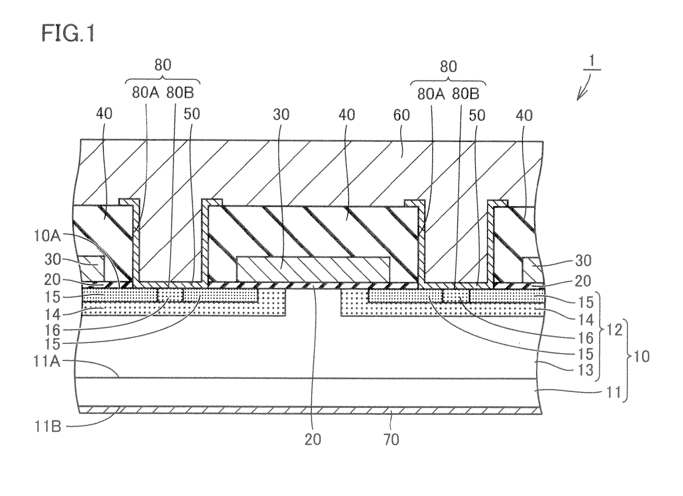

First, the following describes a structure of a MOSFET 1 serving as a semiconductor device according to the present embodiment. Referring to Fig. 1, MOSFET 1 includes a substrate 10 made of silicon carbide, gate insulating films 20, gate electrodes 30, interlayer insulating films 40, source electrodes 50, a source wire 60, and a drain electrode 70. Substrate 10 includes a base substrate 11 and a semiconductor layer 12. In semiconductor layer 12, a drift region 13, body regions 14, source regions 15, and contact regions 16 are formed. Further, in MOSFET 1, contact holes 80 are formed to extend through gate insulating film 20 and interlayer insulating film 40 and expose a main surface 10A of substrate 10.

Base substrate 11 contains an n type impurity such as N (nitrogen) and therefore has n type conductivity (first conductivity type). Drift region 13 is an epitaxial growth layer formed on a main surface 11A of base substrate 11. As with base substrate 11, drift region 13 contains an n type impurity such as N (nitrogen), and therefore has n type conductivity. The concentration thereof in drift region 13 is lower than that in base substrate 11.

Body regions 14 include main surface 10A of substrate 10, and are formed to be separated from each other in semiconductor layer 12. Each of body regions 14 contains a p type impurity such as Al (aluminum) or B (boron), and therefore has p type conductivity (second conductivity type).

Source regions 15 include main surface 10A, and are formed in body regions 14 such that they are surrounded by body regions 14. Each of source regions 15 contains an n type impurity such as P (phosphorus), and therefore has n type conductivity as with base substrate 11 and drift region 13. Further, the concentration of the n type impurity in source region 15 is higher than the concentration of the n type impurity in drift region 13.

As with source region 15, contact regions 16 include main surface 10A, are surrounded by body regions 14, and are respectively formed in body regions 14 so as to be adjacent to source regions 15. As with body region 14, each of contact regions 16 contains a p type impurity such as Al (aluminum) or B (boron) and therefore has p type conductivity. The concentration thereof in contact region 16 is higher than that in body region 14.

Each of gate insulating films 20 is made of, for example, SiO₂ (silicon dioxide), is formed to be disposed on and in contact with main surface 10A and extend from the upper surface of one source region 15 to the upper surface of the other source region 15.

Each of gate electrodes 30 is disposed on and in contact with gate insulating film 20, and is formed to extend from one source region 15 to the other source region 15. Gate electrode 30 is made of a conductor such as polysilicon having an impurity added therein, for example.

Interlayer insulating film 40 is made of for example, SiO₂ (silicon dioxide), and is formed on gate insulating film 20 to surround gate electrode 30. Each of contact holes 80 has side wall surfaces 80A and a bottom surface 80B, and is formed to extend through interlayer insulating film 40 and gate insulating film 20. Further, as shown in Fig. 1, each of side wall surfaces 80A of contact hole 80 is constituted of interlayer insulating film 40 and gate insulating film 20, and bottom surface 80B thereof corresponds to the upper surfaces of source region 15 and contact region 16.

In contact hole 80, source electrode 50 is formed on and in contact with side wall surface 80A and bottom surface 80B. Further, source electrode 50 is made of an alloy containing Ti, Al, and Si, such as a TiAlSi alloy, and is electrically connected to source region 15.

Drain electrode 70 is formed on a main surface 11B of base substrate 11 opposite to main surface 11 A thereof. As with source electrode 50, drain electrode 70 is made of, for example, a TiAlSi alloy, and is electrically connected to base substrate 11.

Source wire 60 is formed to cover source electrode 50 and interlayer insulating film 40. Source wire 60 is made of a metal such as Al (aluminum), and is electrically connected to source region 15 via source electrode 50.

The following describes an operation of MOSFET 1 serving as the semiconductor device according to the present embodiment. Referring to Fig. 1, when a voltage is applied between source electrode 50 and drain electrode 70 while an applied voltage to gate electrode 30 is smaller than a threshold voltage, i.e., while it is in OFF state, a pn junction formed between body region 14 and drift region 13 is reverse-biased. Accordingly, MOSFET 1 is in the non-conductive state. Meanwhile, when gate electrode 30 is fed with a voltage equal to or greater than the threshold voltage, an inversion layer is formed in body region 14. As a result, source region 15 and drift region 13 are electrically connected to each other, whereby a current flows between source electrode 50 and drain electrode 70. In the manner described above, MOSFET 1 operates.

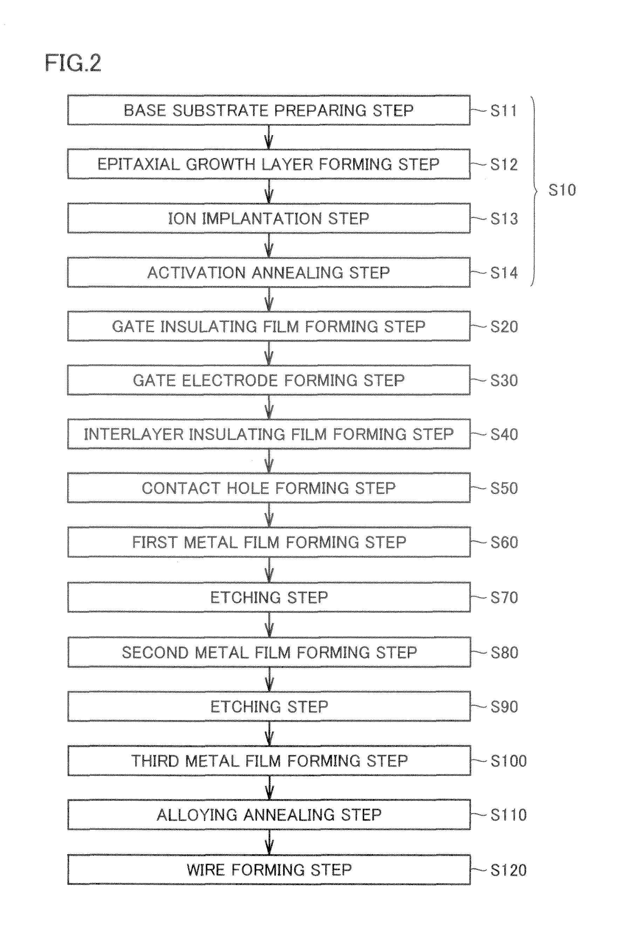

The following describes a method for manufacturing the semiconductor device in one embodiment of the present invention with reference to Fig. 1 to Fig. 13. In the method for manufacturing the semiconductor device in the present embodiment, MOSFET 1 serving as the semiconductor device according to the present embodiment is manufactured. Referring to Fig. 2, a substrate preparing step (S10) is first performed. In this step (S10), steps (S11) to (S 14) described below are performed to prepare substrate 10 made of silicon carbide.

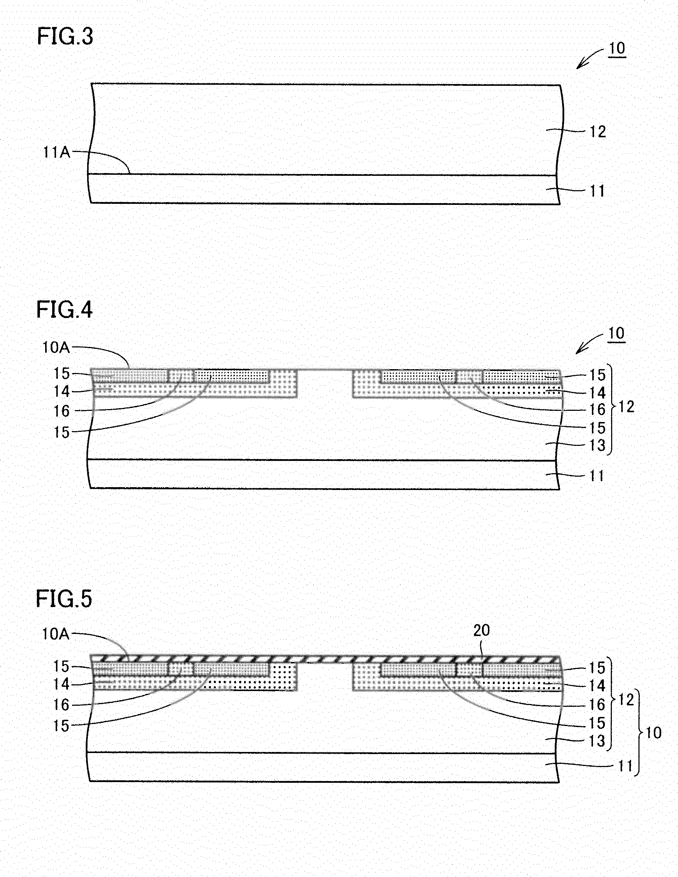

First, as step (S 11), a base substrate preparing step is performed. In this step (S11), referring to Fig. 3, an ingot (not shown) made of, for example, 4H-SiC is sliced to prepare base substrate 11 having n type conductivity.

Next, as a step (S12), an epitaxial growth layer forming step is performed. In this step (S12), referring to Fig. 3, semiconductor layer 12 having n type conductivity is formed by epitaxial growth on main surface 11 A of base substrate 11.

Next, as step (S 13), an ion implantation step is performed. In this step (S 13), referring to Fig. 4, for example, Al ions are first implanted into regions including main surface 10A of substrate 10, thereby forming body regions 14 of p type conductivity in semiconductor layer 12. Next, for example, P ions are implanted into each of body regions 14 at a depth shallower than the depth in which the Al ions have been implanted, thereby forming source region 15 of n type conductivity. Then, for example, Al ions are further implanted into body region 14, thereby forming contact region 16 adjacent to source region 15, having the same depth as that of source region 15, and having p type conductivity. Further, in semiconductor layer 12, a region in which none of body region 14, source region 15, and contact region 16 is formed serves as drift region 13.

Next, as step (S 14), an activation annealing step is performed. In this step (S14), by heating substrate 10, the impurities implanted in step (S13) are activated. Accordingly, desired carriers are generated in the regions having the impurities implanted therein. In this way, by performing steps (S11) to (S 14), substrate 10 is prepared in which an active region is formed by the implantation of the impurities.

Next, as a step (S20), a gate insulating film forming step is performed. In this step (S20), referring to Fig. 5, for example, by heating substrate 10 in an atmosphere containing oxygen, gate insulating film 20 made of SiO₂ (silicon dioxide) is formed to cover main surface 10A of substrate 10.

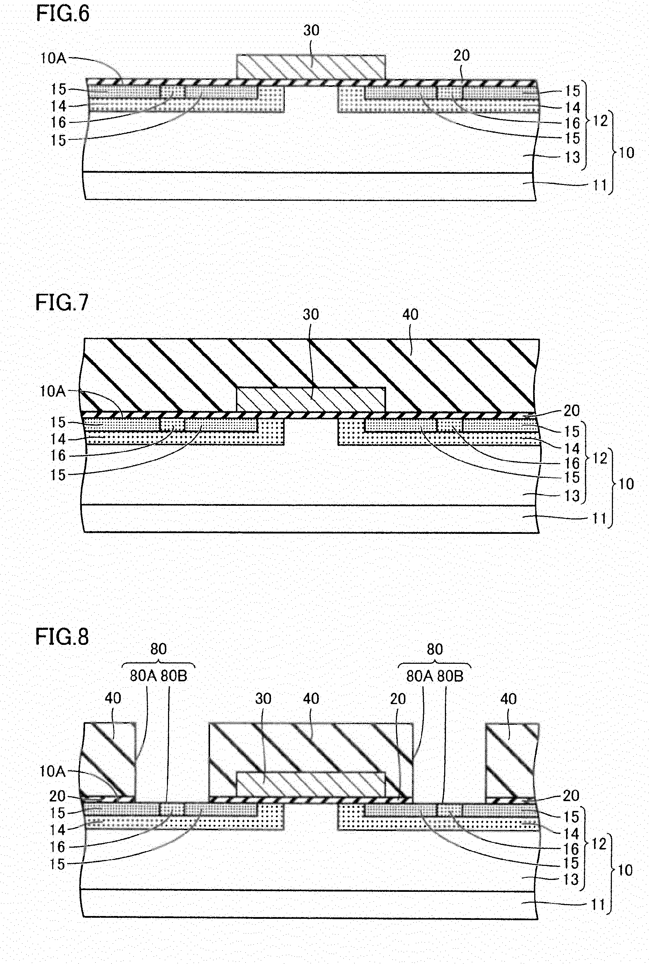

Next, as a step (S30), a gate electrode forming step is performed. In this step (S30), referring to Fig. 6, for example, an LPCVD (Low Pressure Chemical Vapor Deposition) method is employed to form gate electrode 30, which is made of polysilicon containing an impurity, on gate insulating film 20.

Next, as a step (S40), an interlayer insulating film forming step is performed. In this step (S40), referring to Fig. 7, for example, a P (Plasma)-CVD method is employed to form interlayer insulating film 40 made of SiO₂ (silicon dioxide) on gate insulating film 20 such that interlayer insulating film 40 and gate insulating film 20 surround gate electrode 30.

Next, as a step (S50), a contact hole forming step is performed. In this step (S50), referring to Fig. 8, contact hole 80 is formed to have side wall surface 80A and bottom surface 80B and expose main surface 10A of substrate 10. Specifically, for example, an etching method such as RIE (Reactive Ion Etching) is employed to etch through interlayer insulating film 40 and gate insulating film 20, thereby forming contact hole 80 exposing main surface 10A of substrate 10 (the upper surfaces of source region 15 and contact region 16). Further, in this step (S50), contact hole 80 is formed to be separated from gate electrode 30. Hence, as shown in Fig. 8, gate electrode 30 is maintained to be surrounded by gate insulating film 20 and interlayer insulating film 40.

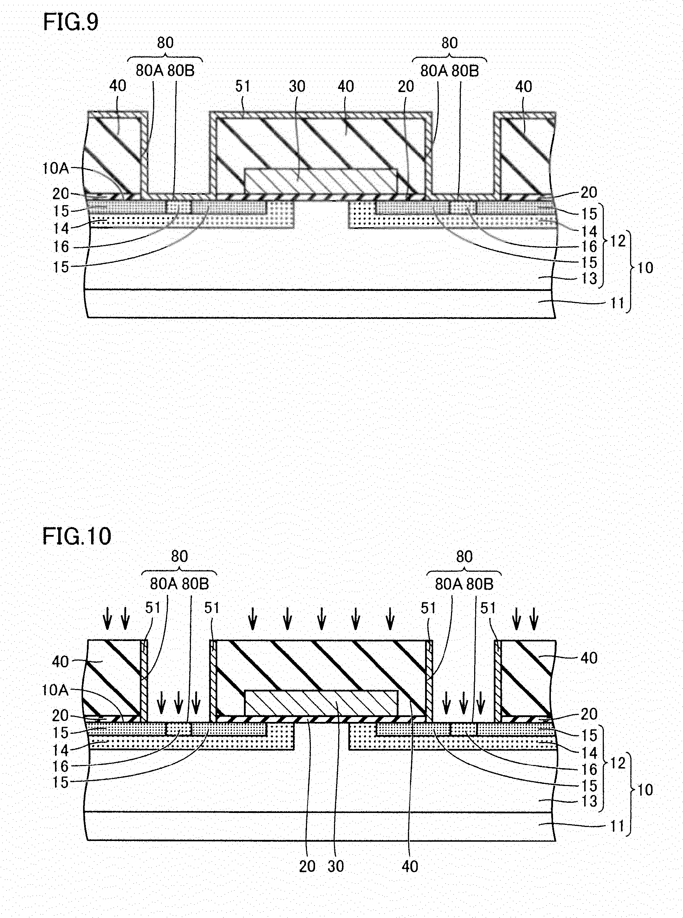

Next, as a step (S60), a first metal film forming step is performed. In this step (S60), referring to Fig. 9, for example, sputtering is performed to form a first metal film 51 on side wall surface 80A and bottom surface 80B of contact hole 80 and the upper surface of interlayer insulating film 40. Formed in this step (S60) is first metal film 51 containing at least one of Ti and Si and containing no Al, such as first metal film 51 made of Ti or Si, first metal film 51 formed of a mixed film of Ti and Si, or a first metal film 51 formed of a stacked film of Ti and Si.

Next, as a step (S70), an etching step is performed. In this step (S70), as indicated by arrows in Fig. 10, dry etching is performed from the side of main surface 10A of substrate 10, thereby removing first metal film 51 from the upper surface of interlayer insulating film 40 and bottom surface 80B of contact hole 80 while first metal film 51 remains on side wall surface 80A of contact hole 80.

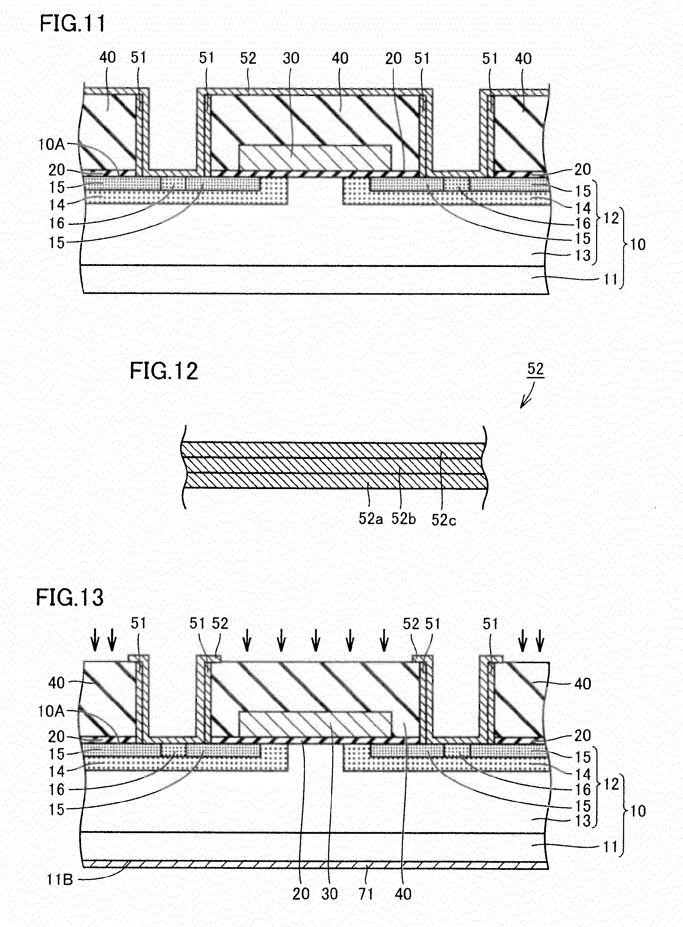

Next, as a step (S80), a second metal film forming step is performed. In this step (S80), a second metal film 52 containing Ti, Al, and Si is formed on and in contact with first metal film 51. Specifically, referring to Fig. 11 and Fig. 12, for example, sputtering is performed to form second metal film 52 structured to include a first metal layer 52a, a second metal layer 52b, and a third metal layer 52c stacked on one another. First metal layer 52a contains Ti. Second metal layer 52b is on and in contact with first metal layer 52a and contains Al. Third metal layer 52c is on and in contact with second metal layer 52b and contains Si. Further, in this step (S80), as described above, a second metal film 52 formed of a stacked film of first to third metal layers 52a, b, c may be formed, or a second metal film 52 in which Ti, Al, and Si are mixed by simultaneously sputtering Ti, Al, and Si may be formed.

Next, as a step (S90), an etching step is performed. In this step (S90), as indicated by arrows in Fig. 13, dry etching is performed from the side of main surface 10A of substrate 10, thereby mainly removing second metal film 52 from the upper surface of interlayer insulating film 40 while second metal film 52 on and in contact with first metal film 51 and bottom surface 80B of contact hole 80 remains.

Next, as a step (S100), a third metal film forming step is performed. In this step (S100), referring to Fig. 13, as with second metal film 52, a third metal film 71 made of, for example, Ti, Al, and Si is formed on main surface 11B of base substrate 11.

Next, as a step (S110), an alloying annealing step is performed. In this step (S100), referring to Fig. 1, first and second metal films 51, 52 formed in steps (S60) and (S80) as well as third metal film 71 formed in step (S100) are heated. Accordingly, Ti, Al, and Si are alloyed, thereby forming source electrodes 50 and drain electrode 70 each made of a TiAlSi alloy.

Next, as a step (S120), a wire forming step is performed. In this step (S120), referring to Fig. 1, for example, a deposition method is employed to form source wire 60, which is made of a conductor such as Al, on and in contact with source electrode 50. By performing steps (S10) to (S120), MOSFET 1 is manufactured, thus completing the method for manufacturing the semiconductor device in the present embodiment.

As described above, in the method for manufacturing the semiconductor device in the present embodiment, source electrode 50 containing Al is formed in the following manner. First, contact hole 80 is formed to extend through interlayer insulating film 40 surrounding gate electrode 30, and first metal film 51 containing at least one of Ti and Si is formed on and in contact with side wall surface 80A of contact hole 80. Next, second metal film 52 containing Ti, Al, and Si is formed on and in contact with first metal film 51. Then, by heating first and second metal films 51, 52, source electrode 50 containing Ti, Al, and Si is formed. Thus, in the method for manufacturing the semiconductor device in the present embodiment, adhesion between source electrode 50 and interlayer insulating film 40 can be improved by forming first metal film 51, which contains at least one of Ti and Si, in advance on and in contact with side wall surface 80A of contact hole 80. Hence, according to the method for manufacturing the semiconductor device in the present embodiment, MOSFET 1 having a stable characteristic can be manufactured by improving adhesion between source electrode 50 containing aluminum and interlayer insulating film 40.

Further, in step (S80) of the present embodiment, second metal film 52 is formed in contact with main surface 10A of substrate 10 exposed by forming contact hole 80, but first metal film 51 may remain to cover main surface 10A. However, by forming second metal film 52 securely in contact with main surface 10A of substrate 10 as in the present embodiment, a composition ratio of Ti, Al, and Si in second metal film 52 can be readily adjusted. As a result, MOSFET 1 having a stable characteristic can be manufactured more readily.

Further, in step (S60) of the present embodiment, first metal film 51 may be formed to have a thickness of not less than 0.1 µm and not more than 1 µm. Thus, the thickness of first metal film 51 can be set in a range necessary and sufficient to improve adhesion between source electrode 50 and interlayer insulating film 40.

Further, in step (S60) of the present embodiment, first metal film 51 may be formed to contain Ti and contain no Al. In this way, the adhesion between source electrode 50 and interlayer insulating film 40 can be further improved.

Further, in the present embodiment, in the case of an IGBT, an emitter electrode can be employed as an electrode having a function of supplying carriers, as with source electrode 50 described above, for example.

The embodiments disclosed herein are illustrative and non-restrictive in any respect. The scope of the present invention is defined by the terms of the claims, rather than the embodiments described above, and is intended to include any modifications within the scope and meaning equivalent to the terms of the claims.

### INDUSTRIAL APPLICABILITY

The method for manufacturing the semiconductor device in the present invention can be particularly advantageously applied to a method for manufacturing a semiconductor device, which is required to manufacture a semiconductor device having a stable characteristic, by improving adhesion between an electrode containing aluminum and an interlayer insulating film.

### REFERENCE SIGNS LIST

1: MOSFET; 10: substrate; 11: base substrate; 10A, 11A, 11B: main surface; 12: semiconductor layer; 13: drift region; 14: body region; 15: source region; 16: contact region; 20: gate insulating film; 30: gate electrode; 40: interlayer insulating film; 50: source electrode; 51: first metal film; 52: second metal film; 52a: first metal layer; 52b: second metal layer; 52c: third metal layer; 60: source wire; 70: drain electrode; 71: third metal film; 80: contact hole; 80A: side wall surface; 80B: bottom surface.

## Claims

1. A method for manufacturing a semiconductor device comprising the steps of:
preparing a substrate (10) made of silicon carbide;
forming a gate insulating film (20) on a surface (10A) of said substrate (10);
forming a gate electrode (30) on said gate insulating film (20);
forming an interlayer insulating film (40) on said gate insulating film (20) so as to surround said gate electrode (30);
forming a contact hole (80) extending through said interlayer insulating film (40) to expose said surface (10A) of said substrate (10) and separated from said gate electrode (30);
forming a first metal film (51) on and in contact with a side wall surface (80A) of said contact hole (80), said first metal film (51) containing at least one of Ti and Si and containing no Al;
forming a second metal film (52) containing Ti, Al, and Si on and in contact with said first metal film (51); and
forming a source electrode (50) containing Ti, Al, and Si by heating said first and second metal films (51, 52).

2. The method for manufacturing the semiconductor device according to claim 1, wherein in the step of forming said second metal film (52), said second metal film (52) is formed in contact with said surface (10A) of said substrate (10) exposed by forming said contact hole (80).

3. The method for manufacturing the semiconductor device according to claim 1 or 2, wherein in the step of forming said second metal film (52), said second metal film (52) is formed to have a first metal layer (52a), a second metal layer (52b), and a third metal layer (52c) stacked on one another, said first metal layer (52a) containing Ti, said second metal layer (52b) being on and in contact with said first metal layer (52a) and containing Al, said third metal layer (52c) being on and in contact with said second metal layer (52b) and containing Si.

4. The method for manufacturing the semiconductor device according to claim 1 or 2, wherein in the step of forming said second metal film (52), said second metal film (52) is formed to contain Ti, Al, and Si mixed with one another.

5. The method for manufacturing the semiconductor device according to any one of claims 1-4, wherein in the step of forming said first metal film (51), said first metal film (51) is formed to have a thickness of not less than 0.1 µm and not more than 1 µm.

6. The method for manufacturing the semiconductor device according to any one of claims 1-5, wherein in the step of forming said first metal film (51), said first metal film (51) is formed to contain Ti and contain no Al.
